(19) Europäisches Patentamt
European Patent Office
Office européen des brevets

(11) EP 1 469 321 A1

(12) # EUROPEAN PATENT APPLICATION

(43) Date of publication:
**20.10.2004 Bulletin 2004/43**

(51) Int Cl.[7]: **G01R 31/36**

(21) Application number: **04008769.4**

(22) Date of filing: **13.04.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **15.04.2003 JP 2003110651**
**15.04.2003 JP 2003110652**
**18.12.2003 JP 2003420483**

(71) Applicant: **Denso Corporation**
**Kariya-city, Aichi-pref., 448-8661 (JP)**

(72) Inventors:
- **Taniguchi, Makoto, Denso Corporation Kariya-city Aichi-pref. 448-8661 (JP)**
- **Ichikawa, Atsushi, Denso Corporation Kariya-city Aichi-pref. 448-8661 (JP)**
- **Hashikawa, Atsushi, Nippon Soken Inc. Nishio-city Aichi-pref. 445-0012 (JP)**
- **Mizuno, Satoru, Nippon Soken Inc. Nishio-city Aichi-pref. 445-0012 (JP)**
- **Sakai, Shoji, Nippon Soken Inc. Nishio-city Aichi-pref. 445-0012 (JP)**
- **Satou, Hiroyuki, Nippon Soken Inc. Nishio-city Aichi-pref. 445-0012 (JP)**
- **Mizuno, Naoki Nagoya-city Aichi-pref. 466-8555 (JP)**
- **Morita, Yoshifumi Nagoya-city Aichi-pref. 466-8555 (JP)**

(74) Representative: **KUHNEN & WACKER**
**Patent- und Rechtsanwaltsbüro**
**Prinz-Ludwig-Strasse 40A**
**85354 Freising (DE)**

(54) **Device for monitoring the state of charge of a battery**

(57) An internal condition detection system (5) detects a charging and discharging current and a terminal voltage of a charge accumulating device (1 ), and learns the internal condition quantity of the charge accumulating device (1) through a neural network (52) based on the current values and the terminal voltage values. The current values and the terminal voltage values are stored in a buffer (51) and supplied as time-series data so that historical information is included. Further the neural network (52) is fed with type information of the charge accumulating device (1). The type information is stored in a memory (53).

FIG. 2

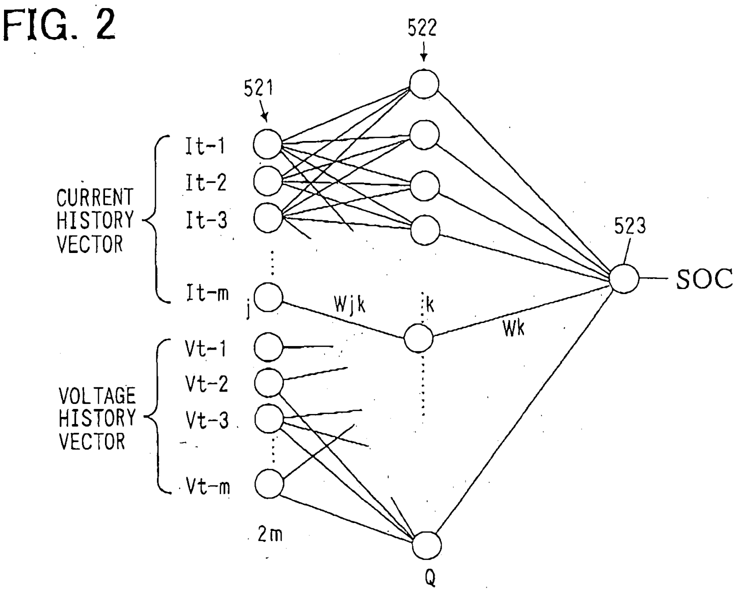


EP 1 469 321 A1

## Description

The present invention relates to an internal condition detection system for a charge accumulating device, which may be used for electric power controllers for power supply for vehicles.

Recently, electronic computerized control of vehicle equipment have been increasingly sophisticated. From such a technological background, reliability of power supply as well as increase in vehicle-mounted power supply capacity need be enhanced. In connection with this, the internal condition of a charge accumulating device such as a storage battery need be detected.

With respect to conventional charge accumulating devices, a method of integrating charging and discharging current values to determine quantity consumed (remaining capacity) has been known in Patent Document 1 (Japanese Patent No. 2910184), for example.

However, in this method, when a current sensor has any error, the error is also integrated. Therefore, errors in the current sensor must be reduced to enhance the accuracy of detection. In general, current sensors use magnetic detection method using Hall IC or voltage detection using a shunt resistor. In the magnetic detection method, the hysteresis characteristic of a magnetic core is not negligible. In the voltage detection using a shunt resistor, the resistance value varies due to self-heating arising from excitation, and temperature compensation must be carried out.

To cope with these problems, a method of using a neural network to estimate the internal condition of a storage battery by learning has been proposed in Patent Document 2 (Japanese Patent Prepublication No. 9-236641) or Patent Document 3 (U.S. Patent No. 6064180), for example.

In general, the learning-type neural network disclosed in Patent Document 2 or Patent Document 3 finds a very favorable input-output relation, where input values (including vectors) and output values (including vectors) can be brought into one-to-one correspondence. However, with respect to the internal condition of a storage battery in which electrochemical reaction occurs, one-to-one relation is difficult to identify. This is because a large hysteresis phenomenon or a nonlinear characteristic arises due to the uneven distribution of concentration of electrolyte or a difference in time constant between diffusion reaction and electrical behavior. For instance, even when the same remaining capacity is indicated, the terminal voltage and the charging and discharging current value are not in one-to-one correspondence with each other.

Further, with the neural network method, the remaining capacity is learned in succession, and initial values need not be determined. Further, errors in a current sensor are instantaneous, and are not accumulated.

However, when the charging and discharging current value of the charge accumulating device are inputted through a neural network, the charging and discharging current value varies depending on the type, especially, the rated capacity of the charge accumulating device For actual vehicles, the rated capacity of the charge accumulating device is provided with a certain range. A charge accumulating device can be replaced with another different in rated capacity in the market. Therefore, when learning is carried out with a charge accumulating device of a specific capacity, the learning data can be invalidated after the charge accumulating device is replaced with another.

The present invention has an object to provide an internal condition detection system for a charge accumulating device, which detects current and voltage values of a charge accumulating device and accumulates these values in a buffer or the like to detect the internal condition such as a remaining capacity of the charge accumulating device.

The present invention has another object to provide an internal condition detection system for a charge accumulating device, which uses information about the type of the charge accumulating device as well as current and voltage values.

According to one aspect of the present invention, an internal condition detection system for a charge accumulating device detects a charging and discharging current and a terminal voltage of the charge accumulating device. The internal condition quantity of the charge accumulating device is learned through a neural network which is fed with the detected current and terminal voltage of the charge accumulating device. The detected current and the terminal voltage are supplied so that historical information is included.

With this construction, with respect to a specific charge accumulating device, a pair of a current vector and a voltage vector can be brought into unique correspondence with the remaining capacity. As a result, the remaining capacity of the charge accumulating device can be detected with accuracy in such an environment, for example, automobile, that power consumption, generator condition, and the number of driving revolutions drastically fluctuate.

According to another aspect of the present invention, an internal condition detection system for a charge accumulating device detects a charging and discharging current and a terminal voltage of the charge accumulating device. The internal condition detection system learns the internal condition quantity of the charge accumulating device through a neural network which is fed with the current and terminal voltage of the charge accumulating device. The neural network is fed with the type information of the charge accumulating device.

With this construction, the internal condition of a plurality of types of charge accumulating devices different in rated capacity can be learned through one neural network. Therefore, the number of types of neural networks can be reduced without impairing learning accuracy.

In addition, neural network coefficients obtained through learning may be written into ROM or the like before shipment. At the same time, the type information of a charge accumulating device may be stored beforehand in ROM or the like. Thus, after marketed, the internal condition of the charge accumulating device can be detected with accuracy and ease. Even when the charge accumulating device is replaced with one of a different type, that can be easily coped with by rewriting the ROM.

The above and other objects, features and advantages of the present invention will become more apparent from the following detailed description made with reference to the accompanying drawings. In the drawings:

FIG. 1 is a block diagram of the first embodiment of the present invention;
FIG. 2 is a structural diagram of a neural network portion in the first embodiment;
FIG 3 is a timing chart illustrating an example of input data in the first embodiment;
FIG. 4 is a flowchart illustrating a process of learning in the first embodiment;
FIG. 5 is a graph showing a voltage-current characteristic of a lead storage battery;
FIG. 6 is a graph showing the voltage-current characteristic of the lead storage battery including historical information,
FIG. 7 is a timing chart illustrating an example of input data in a modification of the first embodiment;
FIG. 8 is a structural diagram of a neural network of two-output system in the modified first embodiment, wherein an internal impedance of a storage battery is learned;
FIG. 9A is a graph showing detection values and true values of a remaining capacity to the number of times of detection when the first range of fluctuation is selected in the second embodiment of the present invention;
FIG. 9B is a graph showing the detection value and true value of remaining capacity SOC to the number of times of detection when the first range of fluctuation and "only charging current values" are selected in the second embodiment;
FIG. 10A is a graph showing the detection value and true value of remaining capacity SOC to the number of times of detection in the third embodiment of the present invention when the charge accumulating device is charged during learning and then the input of current values and terminal voltage values to the neural network is prevented;
FIG. 10B is a graph showing the detection value and true value of remaining capacity SOC to the number of times of detection in the third embodiment when the charge accumulating device is charged during learning and the input of current values and terminal voltage values to the neural network is allowed;
FIG. 11 is a block diagram of the fourth embodiment of the present invention;
FIG. 12 is a structural diagram of a neural network portion in the fourth embodiment,
FIG. 13 is a block diagram of the fifth embodiment of the present invention;
FIG. 14 is a structural diagram of the neural network portion in the fifth embodiment; and
FIG. 15 is a structural diagram of the neural network of two-output system wherein an internal impedance of a storage battery is learned in the sixth embodiment of the present invention.

The present invention will be described in detail with reference to various embodiments.

[First Embodiment]

Referring to FIG. 1 showing an internal condition detection system, numeral 1 denotes a storage battery, which is a charge accumulating device whose condition is to be detected. For the storage battery 1, a lead storage battery, a nickel-metal hydrate battery, a lithium cell, or the like can be used.

Numeral 2 denotes an electric generator driven by a vehicle-mounted engine (not shown). Numeral 3 denotes a vehicle-mounted electrical load or equipment. Numeral 4 denotes a current sensor which detects a charging and discharging current of the storage battery 1, and transmits detection values in the form of digital signals.

Numeral 5 denotes a condition detector for the storage battery 1. The condition detector 5 comprises a buffer portion 51 which is fed with the output signal of the current sensor 4 and the terminal voltage detection signal of the storage battery 1, and stores these input values, and a neural network portion 52 which is fed with signals processed at the buffer portion 51 and outputs the internal condition value, that is, remaining capacity SOC of the battery 1. The electricity generated by the generator 2 is optimally controlled by a generator controller 6 according to the output signal (SOC) from the condition detector 5 and other information 61.

The configuration of the neural network portion 52 in the condition detector 5 is schematically shown in FIG. 2. The neural network portion 52 is of the three-layered feedforward structure, and carries out learning by the error back propagation method. Input information equivalent to a predetermined number of samples is inputted to respective cells 521 so that the history of current values detected by the current sensor 4 and terminal voltage values is included. Here, a data row (It-1 to It-m) having a history is expressed as a vector. The historical data row of current is designated as a current history vector, and the historical data row (Vt-1 to Vt-m) of voltage is designated as a voltage history vector.

Data is sampled by the following method: as illustrated in FIG. 3, a window function which reads in data for the period between the present time and a time a predetermined time before the present time (m pieces in terms of number of samples) is multiplied by a sampling value. Then, the result of the multiplication is accumulated in the buffer 51. In this embodiment, 1.0 is taken for the window function value in the interval m, and 0.0 is taken for the other window function values. That is, data indicated by the solid line in FIG. 3 is taken in as it is. By successively moving the window function in the direction of arrow in the figure, actual data can be taken in. As described above, the input data include two vectors (current history vector and voltage history vector). Therefore, the number of cells 521 in the input layer in the neural network portion 52 is 2m, as illustrated in FIG 2

The remaining capacity of the storage battery 1 at the present time is caused to be learned beforehand with the current history vectors and voltage history vectors in a predetermined charging and discharging pattern. Then, the coupling coefficients between layers are determined to build the neural network.

Next, the algorithm for learning will be described. For learning, a conventional error back propagation method is used.

First, the input data to the j-th cell 521 in the input layer is assumed to be Inj, and the coupling coefficient for the j-th cell 521 in the input layer and the k-th cell 522 in the intermediate layer 522 is assumed to be Wjk. Then, the input signal INPUTk(t) to the k-th cell 522 in the intermediate layer is expressed by Equation (1) below.

$$\mathrm{INPUTk(t)} = \sum(\mathrm{Wjk} * \mathrm{INj}) \qquad (1)$$

where, j = 1 to 2m.

The output signal OUTk(t) from the k-th cell 522 in the intermediate layer is expressed by Equation (2) below.

$$\mathrm{OUTk(t)} = \mathrm{f(INPUTk(t)} + \mathrm{b)} \qquad (2)$$

where, b is a constant.

f(x) in Equation (2) is a nonlinear function designated as sigmoid function, which is a function defined by Equation (3) below

$$f(x) = 1/(1 + \exp(-x)) \qquad (3)$$

Further, the coupling coefficient for the k-th cell 522 in the intermediate layer and the cell 523 in the output layer is assumed to be Wk. Then, the input signal INPUTo(t) to the output layer is expressed by Equation (4) below.

$$\mathrm{INPUTo(t)} = \sum \mathrm{Wk} * \mathrm{OUTk(t)} \qquad (4)$$

where, k = 1 to Q (the number of intermediate layer cells).

The output signal OUTsoc(t) (siginal indicating the remaining capacity) at time t is expressed by the Equation (5) below.

$$\mathrm{OUTsoc(t)} = \mathrm{L} * \mathrm{INPUTo(t)} \qquad (5)$$

where, L is a linear constant.

The process of learning is defined as optimizing the coupling coefficients between cells so that the final output signal OUTsoc(t) at time t will minimize the error from a teacher signal (true value tar(t)).

Next, the method for updating the coupling coefficients will be described.

The coupling coefficient Wk between the k-th cell 522 in the intermediate layer and the cell 523 in the output layer is updated by Equation (6) below.

$$\mathrm{Wk} = \mathrm{Wk} + \Delta\mathrm{Wk} \qquad (6)$$

ΔWk in Equation (6) is defined by Equation (7) below.

$$\Delta Wk = -\eta * \partial Ek/\partial Wk$$
$$= \eta * [OUTsoc(t) - tar(t)] * [\partial OUTsoc(t)/ \partial Wk]$$
$$= \eta * [OUTsoc(t) - tar(t)] * L * [\partial INPUTo(t)/ \partial Wk]$$
$$= \eta * L * [OUTsoc(t) - tar(t)] * OUTk(t) \text{ --- } (7)$$

where, η is a constant.

Ek in Equation (7) is a quantity indicating the error between the teacher data and the network output, and is defined by Equation (8) below.

$$Ek = [OUTsoc(t) - tar(t)]^2/2 \qquad (8)$$

Next, the rule for updating the coupling coefficient Wjk between the k-th cell 522 in the intermediate layer and the j-th cell 521 in the input layer will be described.

The coupling coefficient Wjk is updated by Equation (9) below.

$$Wjk = Wjk + \Delta Wjk \qquad (9)$$

ΔWjk in Equation (9) is defined by Equation (10) below.

$$\Delta Wjk = -\eta * \partial Ek/\partial Wjk$$
$$= -\eta * [\partial Ek/\partial INPUTk(t)] * [\partial INPUTk(t)/ \partial Wjk]$$
$$= -\eta * [\partial Ek/\partial OUTk(t)] * [\partial OUTk(t)/ \partial INPUTk(t)] * INj$$
$$= -\eta * [\partial Ek/\partial OUTsoc(t)] * [\partial OUTsoc(t)/ \partial INPUTo] *$$
$$[\partial INPUTo/OUTk(t)] * f'(INPUTk(t) + b) * INj$$
$$= -\eta * (OUTsoc(t) - tar(t)) * L * Wk *$$
$$f'(INPUTk(t) + b) * INj$$
$$= -\eta * L * Wk * INj * (OUTsoc(t) - tar(t)) *$$
$$f'(INPUTk(t) + b) \text{ --- } (10)$$

Using the new coupling coefficients Wk and Wjk obtained by the above updating, the output signal OUTsoc (t) is computed again. Then, updating the coupling coefficients Wk and Wjk is continued until the error function Ek takes a value equal to or less than a predetermined infinitesimal value.

The process in which the coupling coefficients Wk and Wjk are continuously updated so that the error function Ek will take a predetermined value or smaller value is designated as learning.

FIG. 4 is a flowchart illustrating the process of learning.

First, appropriate initial values are set for the coupling coefficients Wk and Wjk of the neural network portion 52 (step S100). At this time, the initial values can be appropriately determined using random numbers or the like.

Next, a voltage value and a current value for learning are inputted to the neural network portion 52 (step S101). Then, using the initial values of the coupling coefficients Wk and Wjk and the input values inputted to the neural network portion 52, a remaining capacity SOC is computed (step S102). Next, the error function Ek is computed (step S103), and whether the error function Ek is smaller than the predetermined infinitesimal value th is determined (step S104).

When the determination at step S104 reveals that the error function Ek is greater than the infinitesimal value th, the quantity ΔW of updating for the coupling coefficients Wk and Wjk defined in the above process of learning is computed (step S105). Thus, the coupling coefficients Wk and Wjk are updated (step S106). Thereafter, voltage and current values for learning are inputted to the neural network portion 52 to compute the remaining capacity SOC again. When the determination at step S104 reveals that the error function Ek is smaller than the infinitesimal value th, the learning process is terminated (step S107).

Several representative charging and discharging patterns of the process of learning defined as above are adapted to several types of storage batteries before products are shipped. Thus, the remaining capacity of a vehicle-mounted storage battery which has been already put in the market can be computed in succession.

Generally, the terminal voltage and the charging and discharging current of a specific storage battery has a relation shown in FIG. 5 under the same remaining capacity. That is, even when the same remaining capacity is indicated, the terminal voltage and the charging and discharging current are not in one-to-one correspondence with each other. Therefore, according to the first embodiment, based on the finding that the past voltage values and current values, as well as the present current value and voltage value, have non-negligible influence on the present remaining capacity of an electrochemical cell, the remaining capacity is uniquely defined by using historical data (expressed in vector quantity) of voltage value and current value for relation with remaining capacity FIG. 6 is a graph wherein chronological information is superposed on the terminal voltage values and the charging and discharging current values. It is understood from FIG. 6 that obvious relation which depends on the directionality of variation exists between the terminal voltage values and charging and discharging current values.

[Modification to First Embodiment]

A modification to this embodiment will be described below.

The modification to, this embodiment is characterized in the way the voltage value and current values are inputted. In the first embodiment, data in the interval m is uniformly taken out. The modification is characterized in that the time interval of input data is lengthened as it goes farther back into the past from the present moment, as illustrated in FIG. 7.

This way of giving data produces the following advantages.

With respect to some objects, the following is known: the past information cannot be disregarded at the present time, but the degree of its influence on the present time is lowered as it temporally gets away from the present time. For such an object, the above way of giving data accelerates learning cycles. This is thought to be because of the following: even when data is given as illustrated in FIG. 8, the internal coupling coefficients are updated by learning of the neural network portion 52 so that those from the past input cells will be suppressed. With respect to how the distribution of the coupling coefficients Wk and Wjk in the process of determination and after determination in the error back propagation method is correlated with input values and teacher values, an appropriate rule is applied.

Further, information about the temperature of the storage battery 1 is added to input when battery remaining capacity is learned. Thus, the accuracy of computation is enhanced.

Further, a network of two-output system may be constituted to learn the internal impedance of the storage battery 1. The internal impedance of the storage battery 1 is closely related to the conditions of deterioration in electrolyte, electrode plates, or electrode lattices constituting the storage battery 1. Therefore, this is a highly effective method for computing the condition of deterioration in the storage battery 1.

[Second Embodiment]

Learning of the neural network is partly easy and partly difficult depending on the rate of change in current value.

Consequently, in this embodiment, learning is carried out with respect to the input of current values whose fluctuation due to variation 3σ is within a predetermined range.

The following table lists the accuracy of detection obtained by the following procedure: a plurality of storage batteries 1 including a deteriorated storage battery 1 are mounted on a vehicle, and driving is carried out in 10-15 mode At this time, the range of fluctuation in current value is sorted into three: 5A to 15A (first range of fluctuation); 5A to 30A (second range of fluctuation), and 5A to 55A (third range of fluctuation).

With respect to the input of the current values whose range of fluctuation is sorted, learning is carried out on a storage battery 1. Then, the storage battery 1 about which learning has been carried out is replaced with another, and driving is carried out in LA#4 mode. Data obtained at this time is sorted and processed under the conditions of the first to third ranges of fluctuation. The tabulated accuracy of detection is thus obtained.

[Table]

| Range of fluctuation (A) | 5 to 15 (first range) | 5 to 30 (second range) | 5 to 55 (third range) |
|---|---|---|---|
| Accuracy (%) | 55 | 6.1 | 6.3 |

The table reveals the following: as the condition of range of fluctuation in current value due to variation is made stricter, the accuracy of detection is enhanced. More specifically, the first range of fluctuation is narrower than the second range of fluctuation and the third range of fluctuation; therefore, the accuracy of detection is the highest with the first range of fluctuation. FIG. 9A is a graph wherein the result of detection with the first range of fluctuation is plotted.

When only the first range of fluctuation is learned and applied, accurate detection is always carried out. However, when the range of fluctuation in current value is narrowed, the opportunity of current value detection is expected to be reduced For this reason, it is preferable that all the first to third ranges of fluctuation should be learned and applied.

The true value tar(t) is determined by computing the integrated current value back from time when the remaining capacity SOC is 0%.

As input signal to the neural network, data which correlates the history of current value and the history of terminal voltage value with each other may be added to the history of current value and the history of terminal voltage value. Examples of such data include gradient and intercepts obtained by the least squares method, and matching error information.

[Modification to Second Embodiment]

The charging reaction and the discharging reaction in the charge accumulating device 1 are chemical reactions. Therefore, the charging reaction and the discharging reaction are vastly different from each other.

To cope with this, learning is carried out with respect to the input of only charging current values or discharging current values selected.

The condition of "only charging current values" was added to the condition of the first predetermined range and these conditions were applied when learning was carried out. FIG. 9B illustrates the result obtained at that time. As illustrated in FIG. 9B, the accuracy of detection was enhanced from 6.3% to 5.3%. Thus, the accuracy of detection can be enhanced.

[Third Embodiment]

After the charge accumulating device 1 is charged, the voltage is apparently higher than the ordinary voltage due to the influence of polarization voltage. For this reason, learning of the neural network is partly easy and partly difficult due to the influence of charging.

Consequently, in this embodiment, when the charge accumulating device 1 is charged during learning, the data for the period before the charged energy has been discharged is not used. Hereafter, this is referred to as "input with condition selected in this embodiment."

FIG. 10A illustrates the accuracy of detection obtained by the following procedure: a plurality of storage batteries 1 including a deteriorated storage battery 1 are mounted on a vehicle, and driving is carried out in 10-15 mode. At this time, learning is carried out with respect to the input with condition selected in this embodiment. Then, the storage battery 1 about which learning has been carried out is replaced with another, and driving is carried out in LA#4 mode. Data obtained at this time is sorted and processed. The accuracy of detection in the figure is thus obtained.

FIG. 10B illustrates the accuracy of detection obtained by the following procedure: learning is carried out with respect to the input with condition not selected in this embodiment, and data obtained at this time is sorted and processed The accuracy of detection in the figure is thus obtained.

As illustrated in FIG. 10A and FIG. 10B, the accuracy of detection was 6.0% when learning was carried out with respect to the input with condition not selected in this embodiment, and 3.7% when learning was carried out with respect to the input with condition selected in this embodiment.

As described above, the accuracy of detection can be enhanced by carrying out learning with respect to the input with condition selected in the embodiment.

[Fourth Embodiment]

In the fourth embodiment, as shown in FIG. 11, the condition detector 5 has no buffer but has a memory 53, which stores the type information of the storage battery 1. As shown in FIG. 12, the neural network portion 52 in the condition detector 5 of feedforward structure is comprised of three layers: three input layer cells 521, Q intermediate layer cells 522, and an output layer cell 523. The neural network portion 52 carries out learning by the error back propagation method. Input information, that is, the current value and terminal voltage value are inputted to the respective cells 521. Further, the type information of the storage battery 1, for example, hour rate capacity are inputted. The five-hour rate capacity of types representative of lead storage batteries for automobile is digitized and inputted as continuous quantity. For example, for "type designation: five-hour rate capacity [Ah]: input value," such combinations as listed below may be adopted.

34B19:27:27
46B24:36:36
55D23:48:48
80D26:55:55
105D31:64:64

Representation of type information as continuous quantity produces some advantages. For example, it is assumed that learning is carried out at the neural network portion 52 with three combinations, 34B19:27:27, 55D23:48:48, and 105D31:64:64. Thus, types 46B24:36.36 and 80D26:55:55 about which learning has not been carried out yet can be coped with by interpolation based on the result of the learning.

The algorithm of the learning is a conventional error back propagation method, which is defined as the above Equations (1) to (10) described with respect to the first embodiment. The learning for updating the coupling coefficients Wk and Wjk is attained in the similar processing shown in FIG. 4.

Several representative charging and discharging patterns of the process of learning defined as described above are adapted to several types of storage batteries before products are shipped. Thus, the remaining capacity of a vehicle-mounted storage battery which has been already put in the market can be computed in succession

[Fifth Embodiment]

In the fifth embodiment, as input values to the neural network portion 52, a data row having a history of the charging and discharging current values and terminal voltage values of the storage battery is expressed as vector in the similar manner as in the first embodiment. The historical data row of current value is designated as current history vector, and the historical data row of terminal voltage value is designated as voltage history vector.

Data is sampled in the same way as in the first embodiment (FIG. 3). The data taken in is accumulated in a buffer portion 53 illustrated in FIG 13, and is inputted to the neural network portion 52 in succession.

In this case, in addition to the five-hour rate capacity, the internal impedance of the charge accumulating device as it is new is given as battery type information as shown in FIG. 14. The network structure supplied with input as described above has two vectors (current history vector and voltage history vector) and two pieces of type information as input data. Therefore, the number of cells 521 in the input layer of the neural network portion 52 is 2m+2.

Thereafter, the remaining capacity of the storage battery 1 at the present time is caused to be learned with the current history vectors and voltage history vectors in a predetermined charging and discharging pattern. Then, the coupling coefficients Wk and Wjk between layers are determined to build the network.

As described above, the voltage-current characteristic of a lead storage battery for automobile has weak correlation under a specific remaining capacity, as illustrated in FIG. 5. With respect to an object wherein input and output are in one-to-one correspondence, the neural network portion 52 highly effectively learns the object and finds correlation. On the other hand, with respect to an object without one-to-one correspondence, such as a lead storage battery, the neural network portion 52 cannot carry out learning with accuracy. However, when the above historical information is superposed on the lead storage battery, correlation including hysteresis appears, as illustrated in FIG. 6, and one-to-one correspondence can be found. Therefore, when charging and discharging current values and terminal voltage values are inputted as history vectors, the accuracy of detecting the internal condition of the storage battery 1 is dramatically enhanced.

[Modification to Fifth Embodiment]

The modification to this embodiment is characterized in the way the voltage value and current values are inputted. In the fifth embodiment, data in the interval m is uniformly taken out. The modification is characterized in that the time interval of input data is lengthened as it goes farther back into the past, as illustrated in FIG. 7.

This way of giving data produces the following advantage:

With respect to some objects, the following is known: the past information cannot be disregarded at the present time, but the degree of its influence on the present time is lowered as it temporally gets away from the present time. For such an object, the above way of giving data accelerates learning cycles

This is thought to be because of the following: even when data is given as illustrated in FIG. 4, the internal coupling coefficients Wk and Wjk are updated by learning of the neural network portion 52 so that those from the past input cells 521 will be suppressed. With respect to how the distribution of the coupling coefficients Wk and Wjk in the process of determination and after determination in the error back propagation method is correlated with input values and teacher values, an appropriate rule is applied.

Further, information about the temperature of the storage battery 1 is added to input when battery remaining capacity is learned. Thus, the accuracy of computation is enhanced.

[Sixth Embodiment]

In the sixth embodiment, as shown in FIG. 15, a network of two-output system may be constructed to learn the internal impedance of the storage battery 1. The internal impedance of the storage battery 1 is closely related to the condition of deterioration in electrolyte, electrode plates, or electrode lattices constituting the storage battery 1. Therefore, this is a highly effective method for computing the condition of deterioration in the storage battery 1.

The present invention is not limited to the above embodiments and modifications but may be modified in many ways without departing from the spirit of the invention.

## Claims

**1.** An internal condition detection system for a charge accumulating device comprising:

a charge accumulating device (1) for supplying power to an electric system;
a current detecting means (4) for detecting a charging and discharging current of the charge accumulating device; and
a voltage detecting means for detecting a terminal voltage of the charge accumulating device; and
a condition detecting means (5) for detecting an internal condition of the charge accumulating device by learning an internal condition quantity of the charge accumulating device through a neural network (52) which is fed with current values and terminal voltage values output from the current detecting means and the voltage detecting means, respectively,

**characterized in that**
the current values and the terminal voltage values are supplied so that historical information thereof are included.

**2.** The internal condition detection system for a charge accumulating device according to claim 1, further **characterized in that**
the historical information is constituted of time-series data obtained by digitally sampling the current values and the terminal voltage values, and
the time-series data is accumulated and then inputted to an input layer (521) of the neural network.

**3.** The internal condition detection system for a charge accumulating device according to claim 2, further **characterized in that**
data obtained by superposing a time frame on time-series data constituting the historical information and cutting the data is inputted to the input layer of the neural network.

**4.** The internal condition detection system for a charge accumulating device according to claim 2, further **characterized in that**
a time interval of sampled data inputted is made longer as it goes farther back into the past from an internal condition quantity learning time with respect to time-series data constituting the historical information.

**5.** The internal condition detection system for a charge accumulating device according to any one of claims 1 to 4, further **characterized in that**
the internal condition quantity of the charge accumulating device is a dischargeable remaining capacity.

**6.** The internal condition detection system for a charge accumulating device according to any one of claims 1 to 4, further **characterized in that**
the internal condition quantity of the charge accumulating device is an internal impedance of the charge accumulating device.

7. The internal condition detection system for a charge accumulating device for vehicle according to any one of claims 1 to 4, further **characterized in that** the internal condition quantity of the charge accumulating device is a dischargeable remaining capacity of the charge accumulating device and an internal impedance of the charge accumulating device.

8. The internal condition detection system for a charge accumulating device according to any one of claims 1 to 7, further **characterized in that** the neural network is fed with condition quantities related to the temperature of the charge accumulating device.

9. The internal condition detection system for a charge accumulating device according to any one of claims 1 to 8, further **characterized by** comprising:

   a first learning means which, with respect to the input of the current values whose amount of fluctuation due to variation is within a first predetermined range, learns the internal condition of the charge accumulating device and produces an output.

10. The internal condition detection system for a charge accumulating device according to Claim 9, **characterized by** further comprising:

   a second learning means which, with respect to the input of the current values whose amount of fluctuation is within a second predetermined range larger than the first predetermined range, learns the internal condition of the charge accumulating device and produces the output.

11. The internal condition detection system for a charge accumulating device according to claim 9 or 10, further **characterized in that** the amount of fluctuation is computed using a variance or standard deviation of the current values.

12. The internal condition detection system for a charge accumulating device according to any one of claims 1 to 11, further **characterized by** comprising:

   a charging current learning means which, with respect to the input of the charging current values, learns the internal condition of the charge accumulating device and produces output.

13. The internal condition detection system for a charge accumulating device according to any one of claims 1 to 12, further **characterized by** comprising:

   a discharging current learning means which, with respect to the input of the discharging current value, learns the internal condition of the charge accumulating device and produces output.

14. The internal condition detection system for a charge accumulating device according to any one of claims 1 to 13, further **characterized in that** the current values and the terminal voltage values are supplied so that correlation data correlated with the historical information is included.

15. The internal condition detection system for a charge accumulating device according to claim 14, further **characterized in that** the correlation data is gradient and intercepts obtained by the least squares method or matching error.

16. The internal condition detection system for a charge accumulating device according to any one of claims 1 to 15, further **characterized in that** the internal condition quantity of the charge accumulating device is a ratio of the dischargeable remaining capacity to a full charge capacity of the charge accumulating device.

17. The internal condition detection system for a charge accumulating device according to any one of claims 1 to 16, further **characterized by** comprising:

a charged input stopping means which, when the charge accumulating device is charged during learning, prevents the input of the current values and the terminal voltage values to the neural network until energy charged in the charge accumulating device is discharged.

**18.** An internal condition detection system for a charge accumulating device comprising:

a charge accumulating device (1) for supplying power to an electric system (3);
a current detecting means (4) for detecting a charging and discharging current of the charge accumulating device;
a voltage detecting means for detecting a terminal voltage of the charge accumulating device; and
an internal condition detecting means (5) for detecting an internal condition of the charge accumulating device by learning an internal condition quantity of the charge accumulating device through a neural network (52) which is fed with current values and terminal voltage values of the charge accumulating device and producing an output,

**characterized in that**
the neural network (52) is fed with type information indicative of types of the charge accumulating device.

**19.** The internal condition detection system for a charge accumulating device according to claim 18, further **characterized in that**
the type information is digitized and inputted to the neural network.

**20.** The internal condition detection system for a charge accumulating device according to claim 19, further **characterized in that**
the type information is represented as continuous quantity and is a numerical value correlated with an hour rate capacity.

**21.** The internal condition detection system for a charge accumulating device according to claim 19, further **characterized in that**
the type information is represented as continuous quantity and is a numerical value correlated with an internal impedance of the charge accumulating device.

**22.** The internal condition detection system for a charge accumulating device according to any one of claims 18 to 21, further **characterized in that**
the neural network is supplied with the current values and the terminal voltage values so that historical information is included.

**23.** The internal condition detection system for a charge accumulating device according to claim 22, further **characterized in that**
the historical information is comprised of time-series data obtained by digitally sampling the current values and the terminal voltage values and the time-series data is accumulated and inputted to an input layer (521) of the neural network.

**24.** The internal condition detection system for a charge accumulating device according to claim 23, further **characterized in that**
data obtained by superposing a time frame on time-series data constituting the historical information and cutting the data is inputted to the input layer of the neural network.

**25.** The internal condition detection system for a charge accumulating device according to claim 23, further **characterized in that**
with respect to time-series data constituting the historical information, a time interval of sampled data inputted is made longer as it goes farther back into the past from an internal condition quantity learning time.

**26.** The internal condition detection system for a charge accumulating device for vehicle according to any one of claims 18 to 25, further **characterized in that**
the internal condition quantity of the charge accumulating device is a dischargeable remaining capacity.

**27.** The internal condition detection system for a charge accumulating device according to any one of claims 18 to 26, further **characterized in that**

the internal condition quantity of the charge accumulating device is the internal impedance of the charge accumulating device.

**28.** The internal condition detection system for a charge accumulating device according to any one of claims 18 to 27, further **characterized in that**

the neural network is fed with condition quantities related to the temperature of the charge accumulating device.

FIG. 1

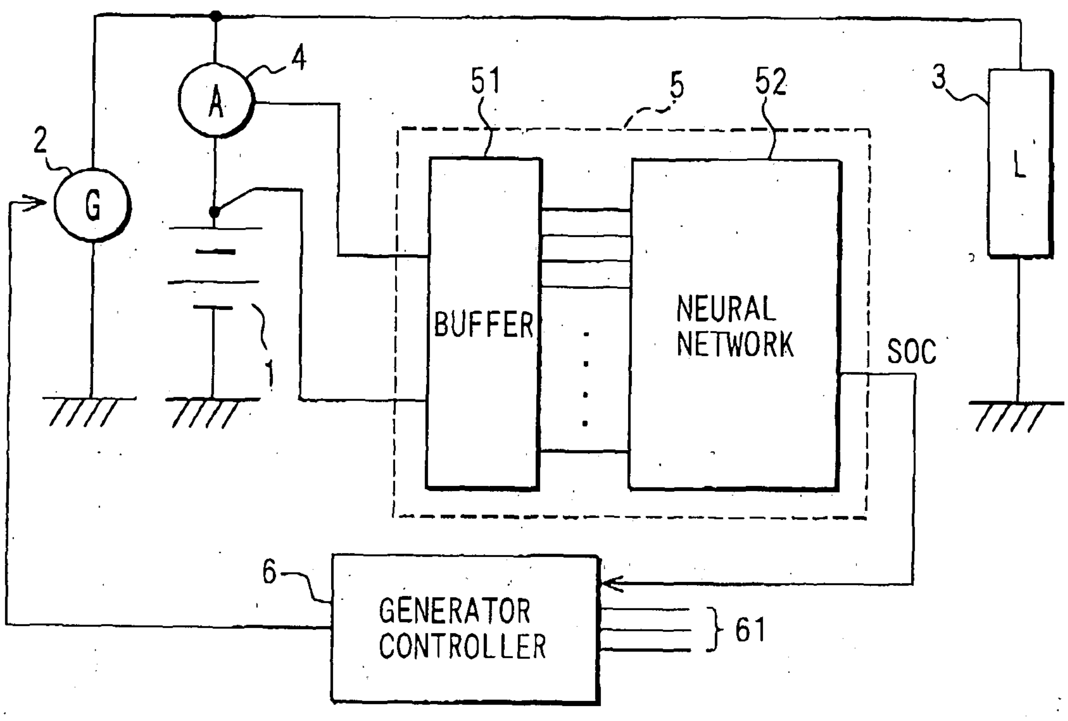
2
G
4
A
1
51
5
52
BUFFER
NEURAL
NETWORK
SOC
3
L
6
GENERATOR
CONTROLLER
61

FIG. 2

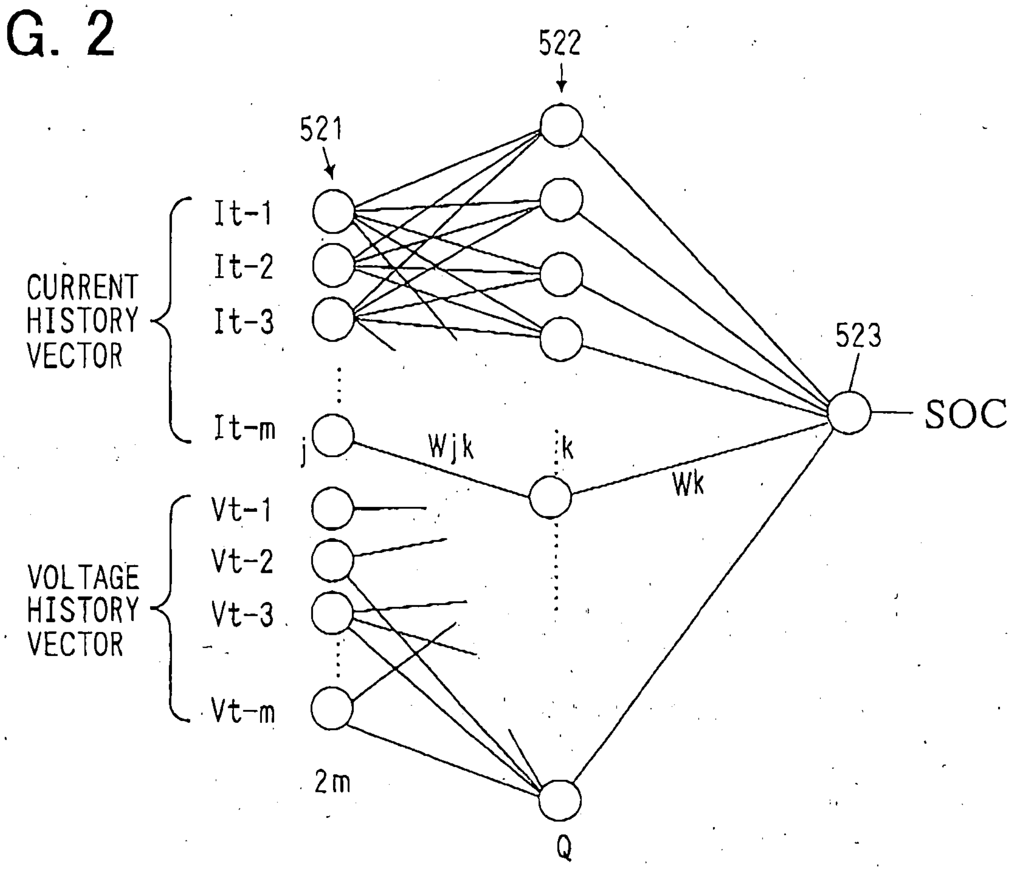
522
521
523
CURRENT
HISTORY
VECTOR
It-1
It-2
It-3
It-m
j
Wjk
k
Wk
SOC
VOLTAGE
HISTORY
VECTOR
Vt-1
Vt-2
Vt-3
Vt-m
2m
Q

FIG. 3

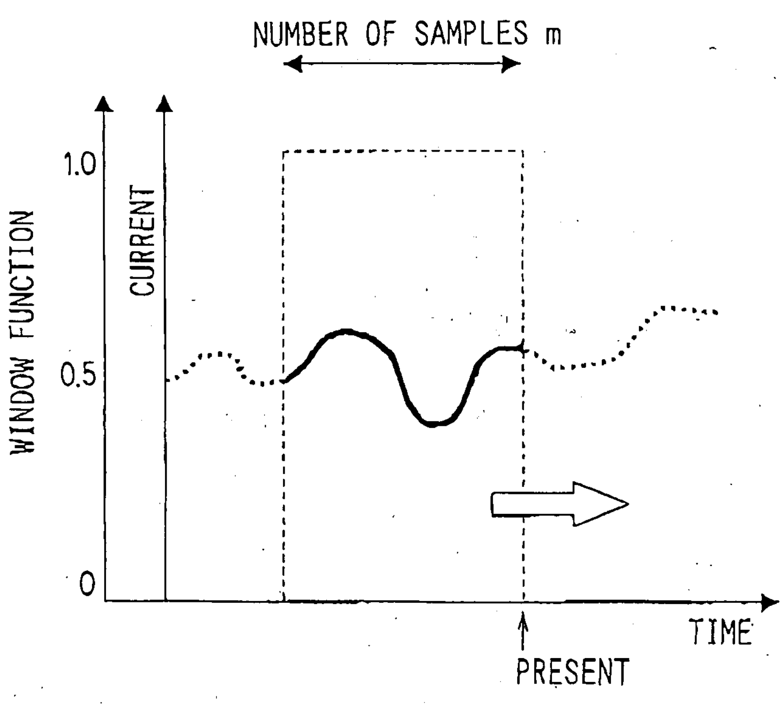
NUMBER OF SAMPLES m
1.0
0.5
0
WINDOW FUNCTION
CURRENT
TIME
PRESENT

FIG. 4

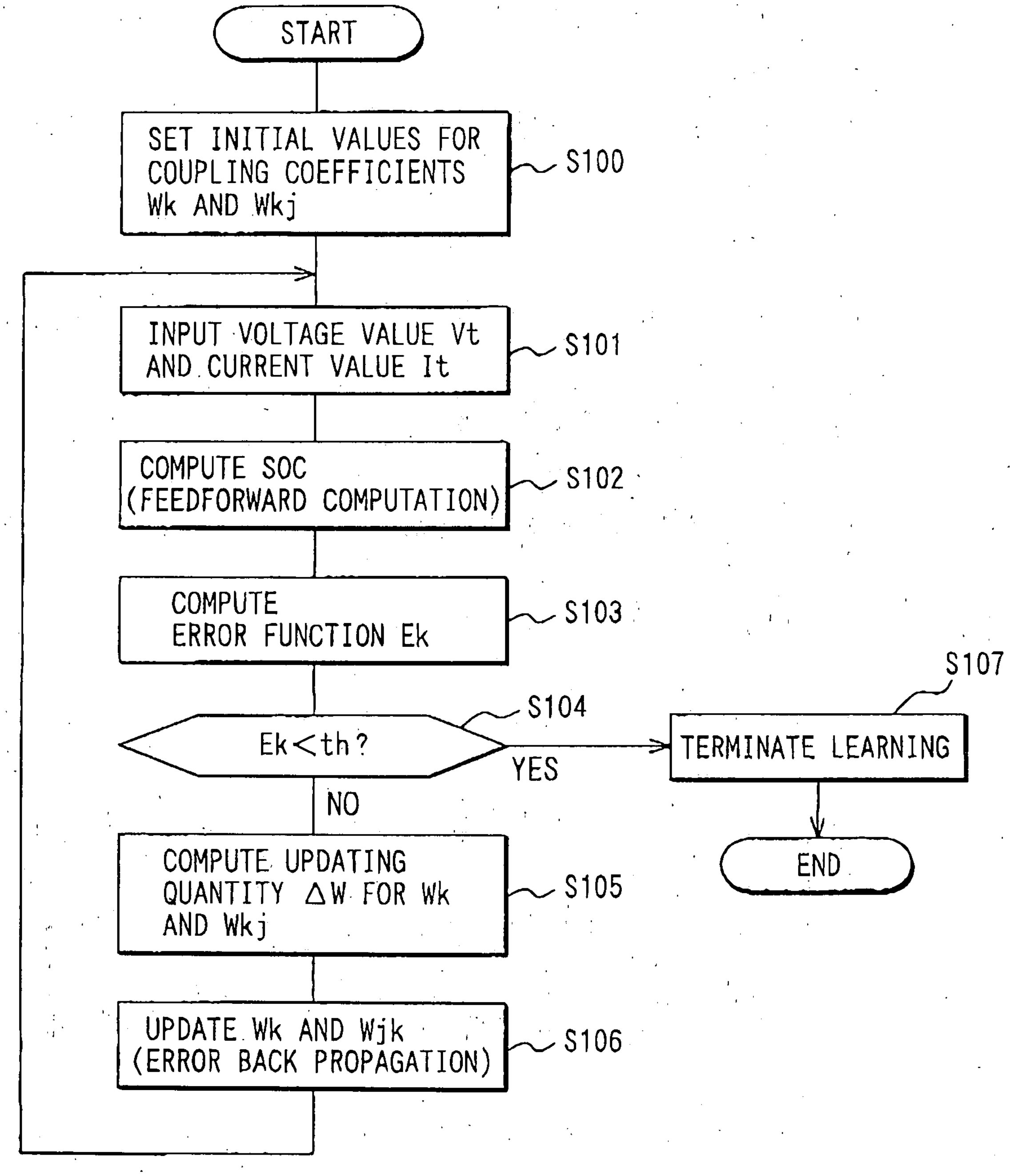
START
SET INITIAL VALUES FOR COUPLING COEFFICIENTS Wk AND Wkj
S100
INPUT VOLTAGE VALUE Vt AND CURRENT VALUE It
S101
COMPUTE SOC (FEEDFORWARD COMPUTATION)
S102
COMPUTE ERROR FUNCTION Ek
S103
Ek<th?
S104
YES
NO
TERMINATE LEARNING
S107
END
COMPUTE UPDATING QUANTITY ΔW FOR Wk AND Wkj
S105
UPDATE Wk AND Wjk (ERROR BACK PROPAGATION)
S106

FIG. 5

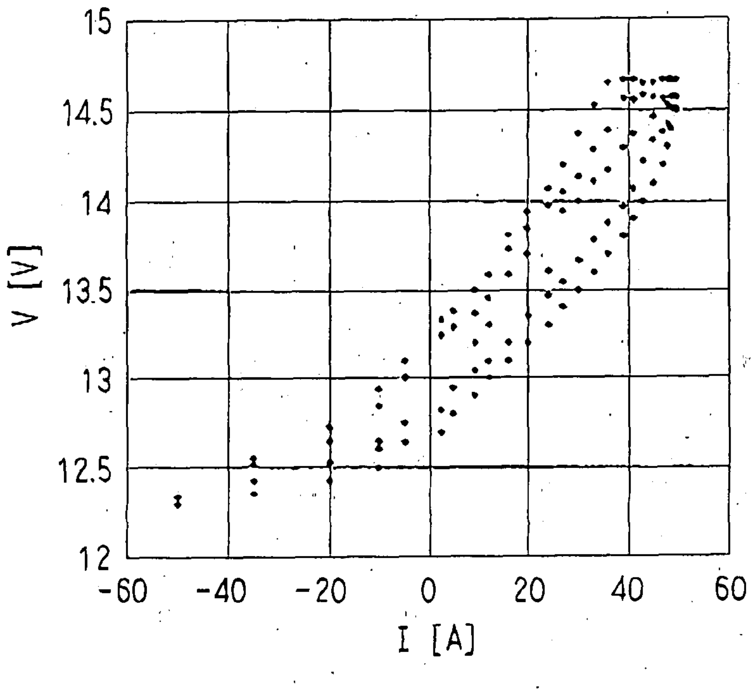
15
14.5
14
13.5
13
12.5
12
V [V]
-60
-40
-20
0
20
40
60
I [A]

FIG. 6

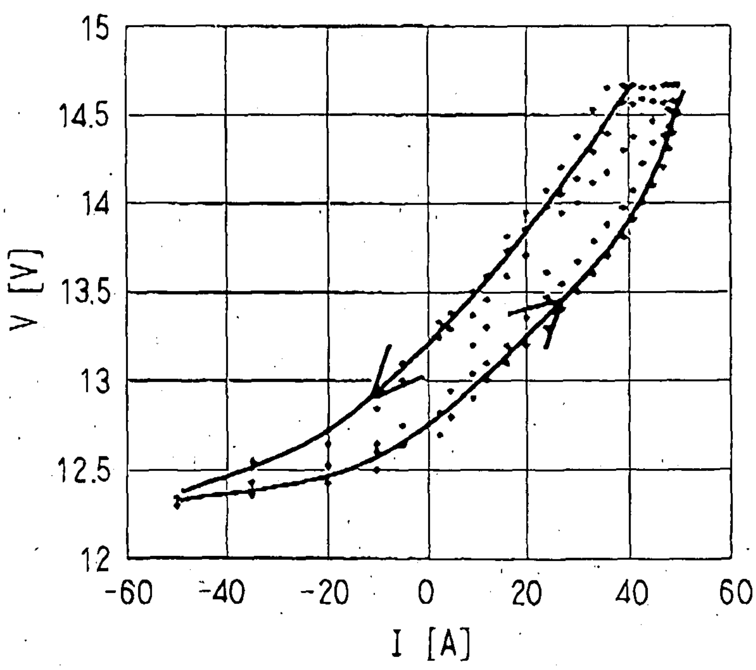
15
14.5
14
13.5
13
12.5
12
V [V]
-60
-40
-20
0
20
40
60
I [A]

FIG. 7

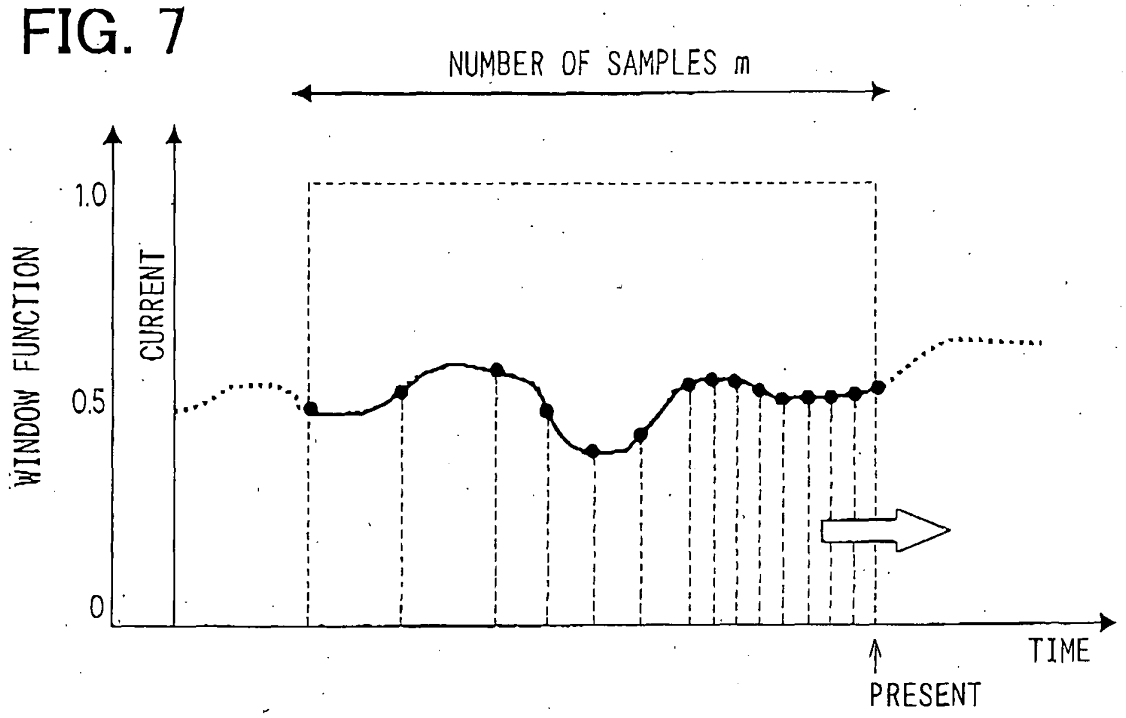
NUMBER OF SAMPLES m
1.0
0.5
0
WINDOW FUNCTION
CURRENT
TIME
PRESENT

FIG. 8

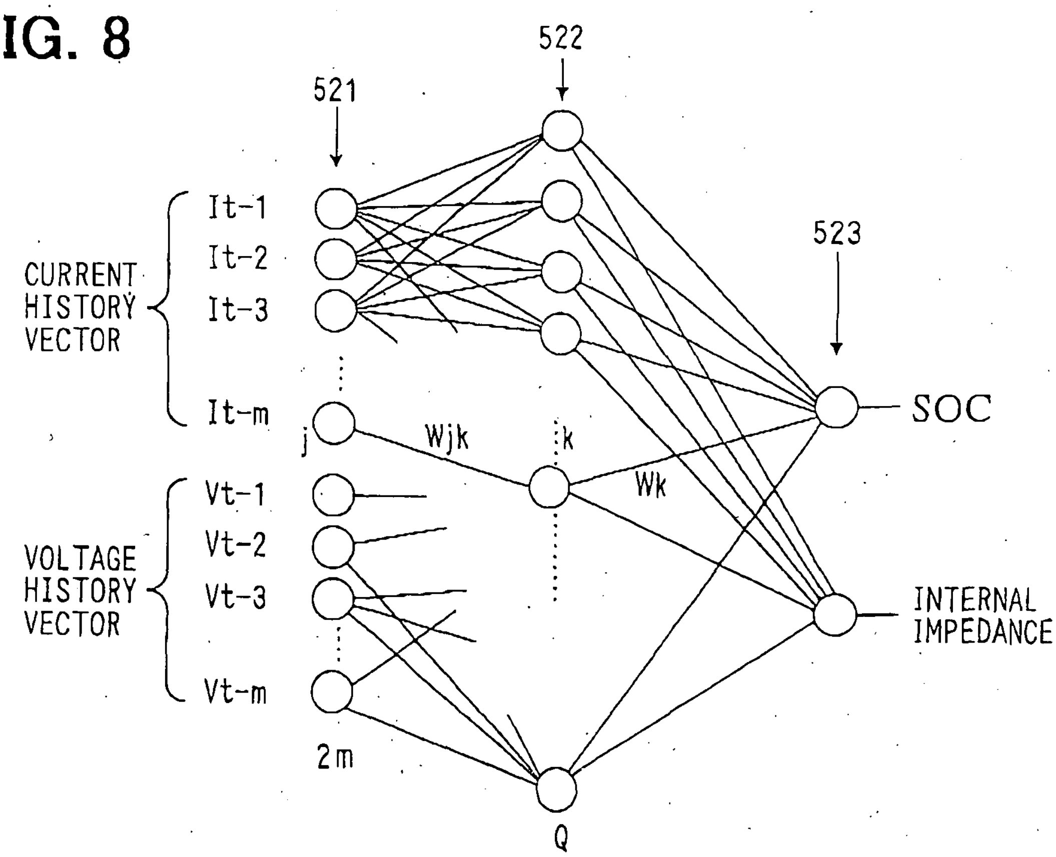
522
521
523
CURRENT HISTORY VECTOR
It-1
It-2
It-3
It-m
j
Wjk
k
Wk
SOC
VOLTAGE HISTORY VECTOR
Vt-1
Vt-2
Vt-3
Vt-m
2m
Q
INTERNAL IMPEDANCE

FIG. 9A

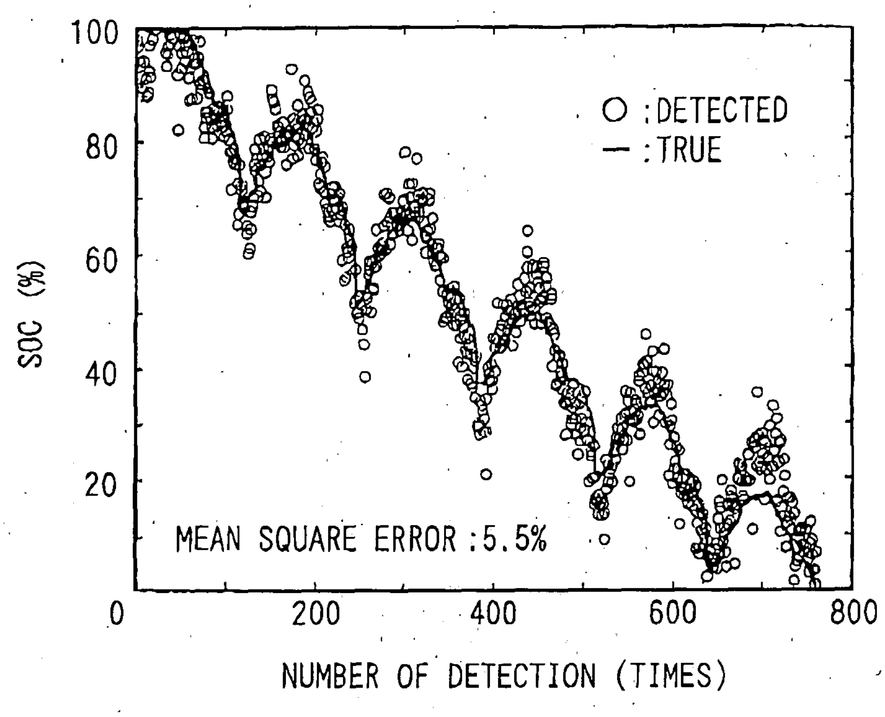
100
80
60
40
20
0
SOC (%)
O :DETECTED
— :TRUE
MEAN SQUARE ERROR :5.5%
200
400
600
800
NUMBER OF DETECTION (TIMES)

FIG. 9B

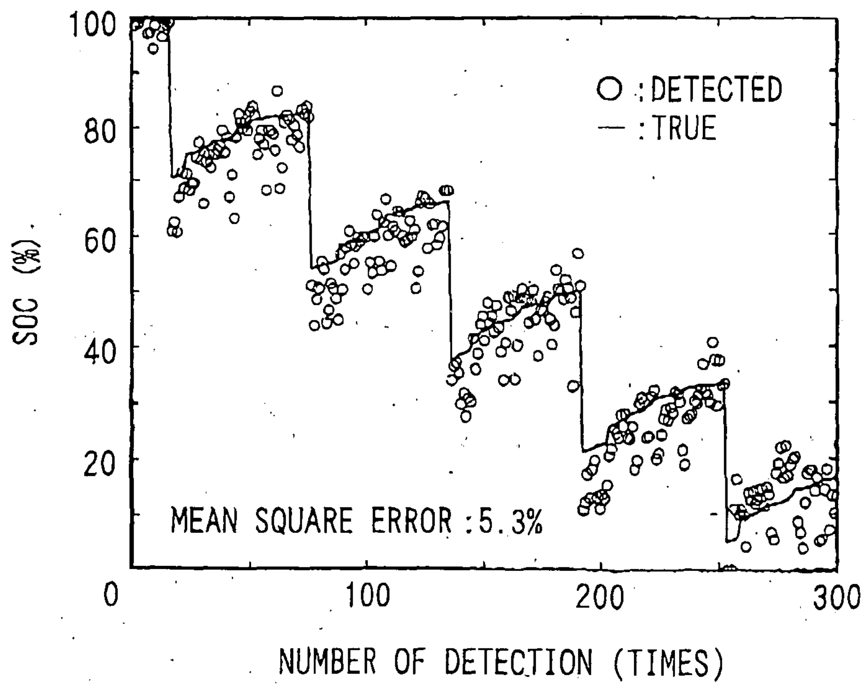
100
80
60
40
20
0
SOC (%)
O :DETECTED
— :TRUE
MEAN SQUARE ERROR :5.3%
100
200
300
NUMBER OF DETECTION (TIMES)

FIG. 10A

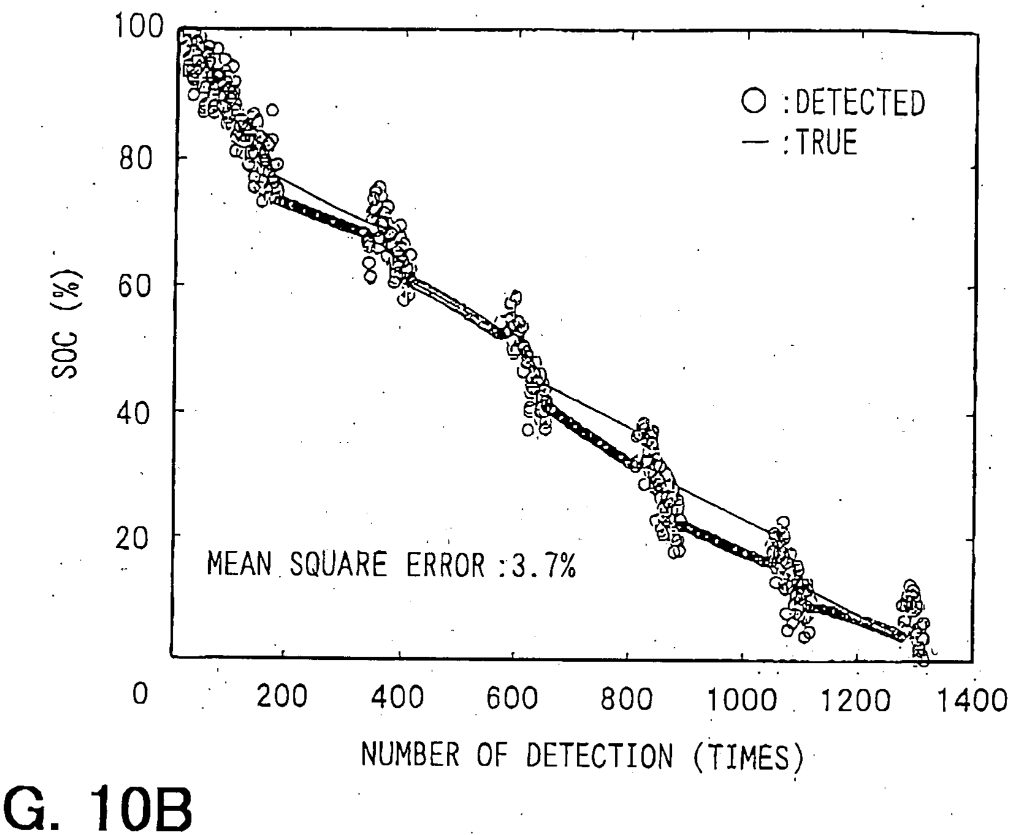


FIG. 10B

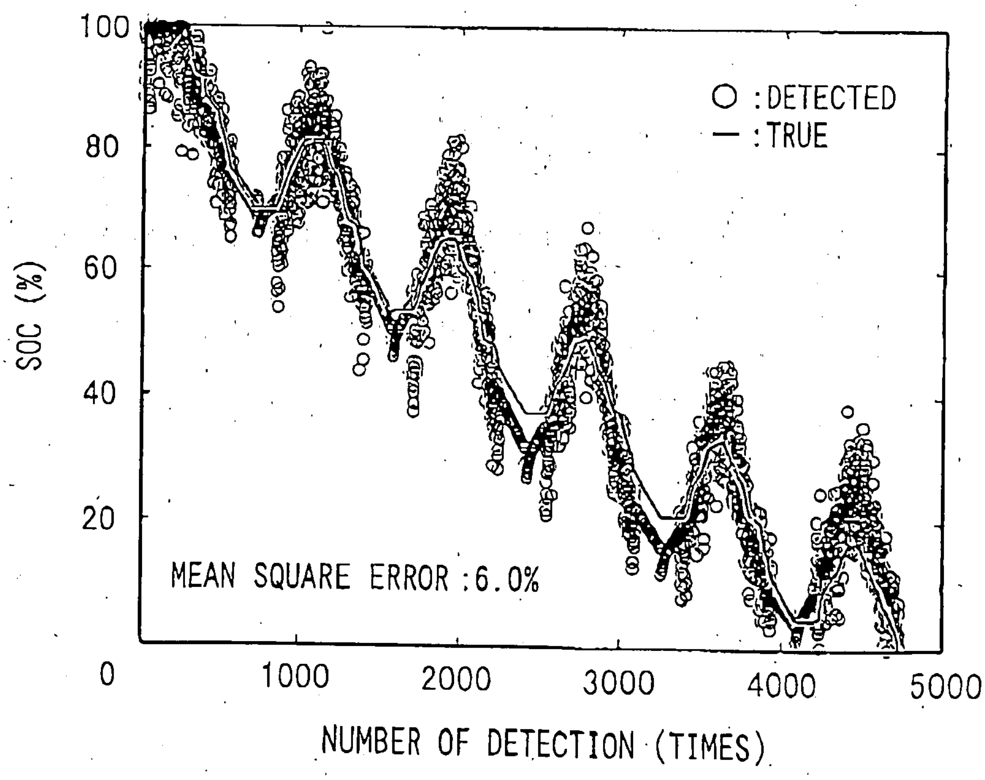

FIG. 11

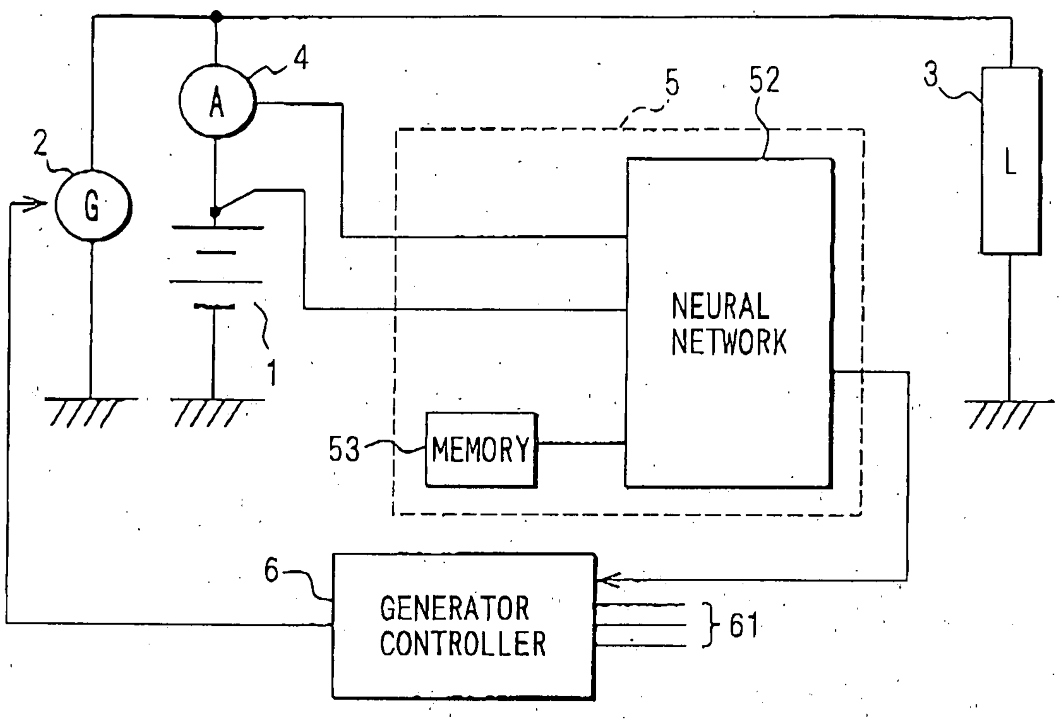
4
A
5
52
3
2
G
L
NEURAL
NETWORK
1
53
MEMORY
6
GENERATOR
CONTROLLER
61

FIG. 12

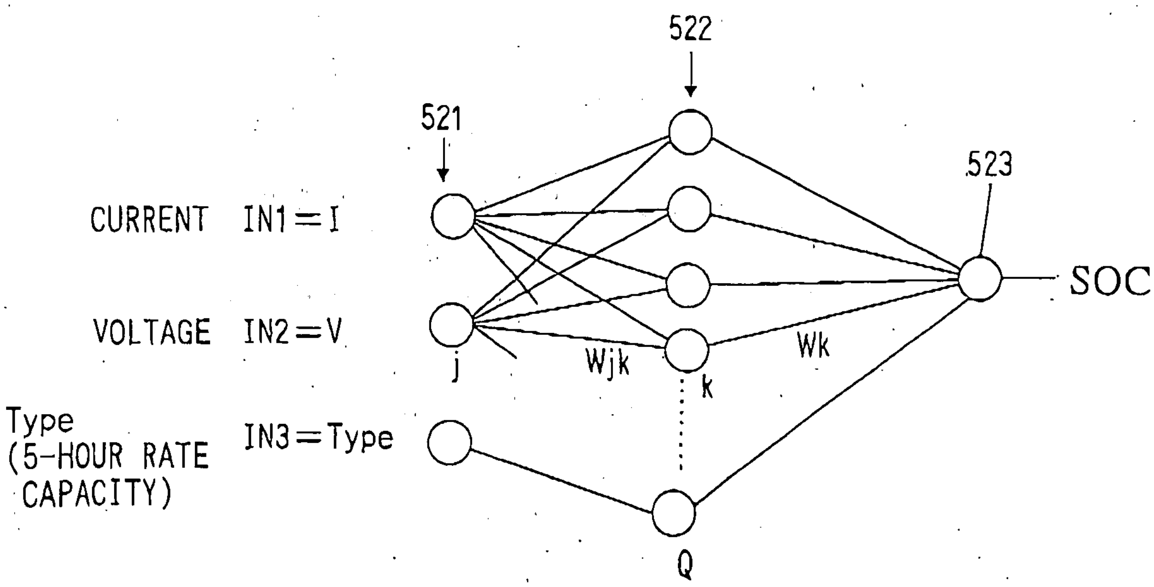
522
521
523
CURRENT IN1=I
VOLTAGE IN2=V
Type
(5-HOUR RATE
CAPACITY)
IN3=Type
SOC
j
Wjk
k
Wk
Q

FIG. 13

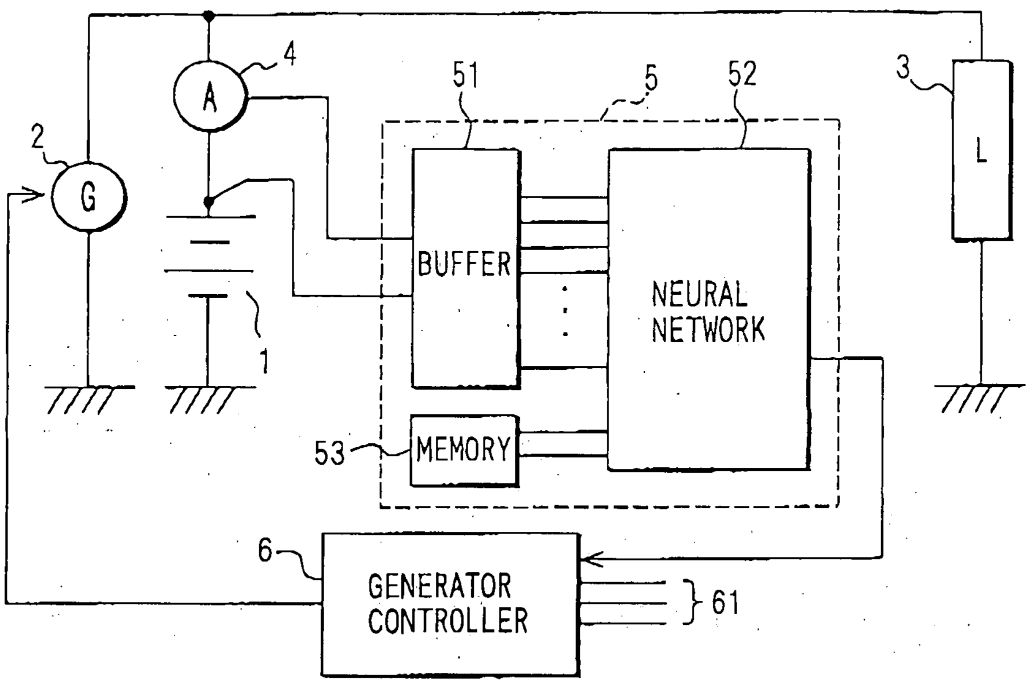
4
51
5
52
3
2
A
G
L
BUFFER
NEURAL
NETWORK
1
53
MEMORY
6
GENERATOR
CONTROLLER
61

FIG. 14

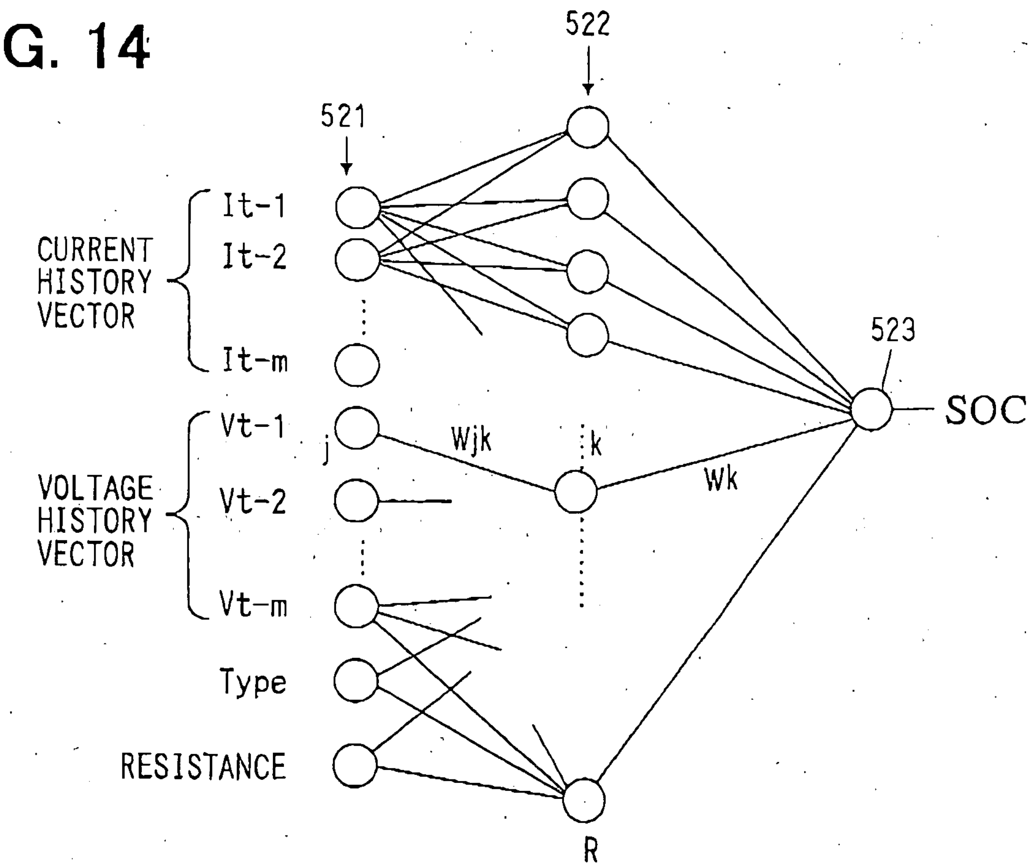
522
521
CURRENT
HISTORY
VECTOR
It-1
It-2
It-m
523
VOLTAGE
HISTORY
VECTOR
Vt-1
j
Wjk
k
SOC
Wk
Vt-2
Vt-m
Type
RESISTANCE
R

FIG. 15

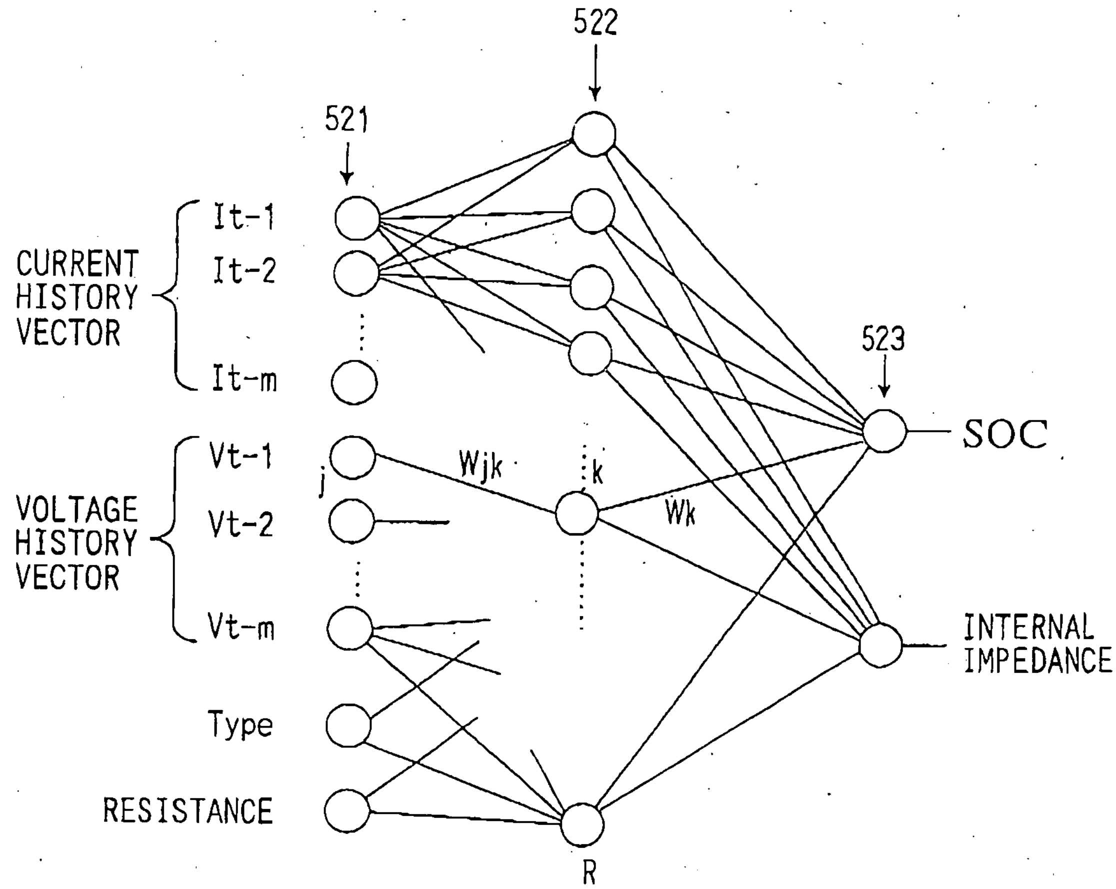
522
521
523
CURRENT HISTORY VECTOR
It-1
It-2
It-m
VOLTAGE HISTORY VECTOR
Vt-1
Vt-2
Vt-m
Type
RESISTANCE
j
Wjk
k
Wk
R
SOC
INTERNAL IMPEDANCE

European Patent Office

# EUROPEAN SEARCH REPORT

Application Number
EP 04 00 8769

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A,D<br>Y | US 6 064 180 A (EBERHART RUSSELL CARLEY ET AL) 16 May 2000 (2000-05-16)<br>see fig 2 of document and fig 2 of aplication<br>----- | 1-17<br>18 | G01R31/36 |
| Y | US 5 831 435 A (TROY MICHAEL E) 3 November 1998 (1998-11-03)<br>* abstract *<br>----- | 18 | |

TECHNICAL FIELDS SEARCHED (Int.Cl.7)
G01R

The present search report has been drawn up for all claims

| Place of search | Date of completion of the search | Examiner |
|---|---|---|
| The Hague | 22 July 2004 | Vytlacilová, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 04 00 8769

This annex lists the patent family membersrelating to the patent documents cited in the above-mentioned European search report.
The members are as contained in the European Patent Office EDP file on
The European Patent Office is in no way liable for these particulars which are merely given for the purpose of information.

22-07-2004

| Patent document cited in search report | | Publication date | Patent family member(s) | Publication date |
|---|---|---|---|---|
| US 6064180 | A | 16-05-2000 | NONE | |
| US 5831435 | A | 03-11-1998 | NONE | |

EPO FORM P0459

For more details about this annex : see Official Journal of the European Patent Office, No. 12/82